**Europäisches Patentamt**

**European Patent Office**

**Office européen des brevets**

(19)

(11) Veröffentlichungsnummer: **0 180 153
B1**

(12) **EUROPÄISCHE PATENTSCHRIFT**

(45) Veröffentlichungstag der Patentschrift:
16.08.89

(51) Int. Cl.⁴: **H 03 D 3/24**

(21) Anmeldenummer: 85113542.6

(22) Anmeldetag: 24.10.85

(54) Digitaler quarzstabiler FM-Diskriminator.

(30) Priorität: 31.10.84 DE 3439825

(43) Veröffentlichungstag der Anmeldung:
07.05.86 Patentblatt 86/19

(45) Bekanntmachung des Hinweises auf die Patenterteilung:
16.08.89 Patentblatt 89/33

(84) Benannte Vertragsstaaten:
AT BE CH DE FR GB IT LI LU NL SE

(56) Entgegenhaltungen:
GB-A- 2 114 832
US-A- 3 936 762

IBM TECHNICAL DISCLOSURE BULLETIN, Band 13, Nr. 11, April 1971, Seiten 3421-3422, New York, US; G.D. JONES, Jr.: "Digital frequency discriminator"
FUNKSCHAU, Band 48, Nr. 7, März 1976, Seiten 257-258, München, DE; M. KASZTANTOWICZ: "Phase-locked-loop-systeme in der Praxis"

(73) Patentinhaber: **Siemens Aktiengesellschaft, Wittelsbacherplatz 2, D-8000 München 2 (DE)**

(72) Erfinder: **Hofmann, Ludwig, Dipl.-Ing.(FH), Jahnhöhe 60, D-8068 Hettenshausen (DE)**

## Beschreibung

Die Erfindung bezieht sich auf einen digitalen quarzstabilen FM-Diskriminator mit einer Phasenregelschleife (PLL: Phase Locked Loop), die einen Phasenvergleicher und einen umschaltbaren Frequenzteiler enthält, bei dem dem Phasenvergleicher das Eingangssignal des Diskriminators und das Ausgangssignal des Frequenzteilers und dem Frequenzteiler eine quarzstabile Frequenz und das Ausgangssignal des Phasenvergleichers zugeführt werden. Eine solche Schaltungsanordnung ist im wesentlichen aus der US-A-3 983 498 bekannt.

PLL (Phase Locked Loop)-Demodulatoren, die in üblicher Weise einen VCO (Voltage controlled oscillator) über einen Tiefpass so nachregeln, dass die VCO-Frequenz gleich der Eingangsfrequenz ist, wobei die Regelspannung am VCO der NF-Spannung entspricht, haben den Nachteil, dass die VCO's wegen ihrer Temperatur- und Spannungsabhängigkeit nur schwer zu stabilisieren sind. Dies macht es erforderlich, dass der VCO abgeglichen werden muss. Die Kennlinie des VCO entspricht der Demodulatorkennlinie, was bedeutet, dass Unlinearitäten einen Klirrfaktor ergeben.

Bei Ansteuerung des VCO ohne Tiefpass ergibt sich ein digitaler Zweipunktregler. Der VCO erzeugt nur zwei Frequenzen, die der niedrigsten und höchsten demodulierbaren Frequenz entsprechen. Das Tastverhältnis entspricht dem Verhältnis der Eingangsfrequenz zu den beiden möglichen VCO-Frequenzen.

Der Erfindung liegt die Aufgabe zugrunde, einen FM-Diskriminator zu schaffen, der möglichst linear, temperaturunabhängig und frequenzstabil ist.

Diese Aufgabe wird für einen FM-Diskriminator der eingangs beschriebenen Art gemäss der Erfindung in der Weise gelöst, dass im Signalübertragungsweg am Verbindungspunkt vom Ausgang des Phasenvergleichers und Eingang des Frequenzteilers ein Tiefpass eingeschaltet ist, dem das Ausgangssignal des Phasenvergleichers zugeführt wird und dessen Ausgang eine Spannung $U_{Nf}$ entnehmbar ist, dass der Frequenzteiler durch Umschalten ein Signal erzeugt, das die Eckfrequenzen $f_u$ und $f_o$ des Diskriminators enthält und dass die Frequenz des Eingangssignals $f_{Ein} = a\,f_o + b\,f_u$ ist, wobei $a+b = 1$ ist und a und b das Tastverhältnis des dem Frequenzteiler als Steuersignal zugeführten Ausgangssignals des Phasenvergleichers angeben.

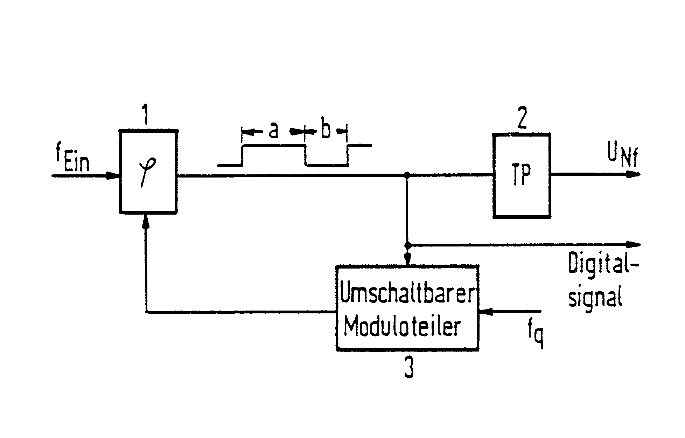

Nachstehend wird die Erfindung anhand eines in der Zeichnung dargestellten Ausführungsbeispiels näher erläutert.

Die Figur zeigt den FM-Diskriminator im Blockschaltbild. Das Eingangssignal der Frequenz $f_{Ein}$ wird einem Phasenvergleicher 1 zugeführt. Diesem ist ein Tiefpass 2 nachgeschaltet, dessen Ausgang die Spannung $U_{NF}$ (Niederfrequenzsignal) entnehmbar ist. Vom Signalweg zwischen Phasenvergleicher 1 und Tiefpass 2 ist eine PLL-Schleife zu einem weiteren Eingang des Phasenvergleichers 1 eingeschaltet. Diese enthält einen umschaltbaren Moduloteiler 3, dem eine quarzstabile Frequenz $f_q$ zugeführt wird. Der umschaltbare Moduloteiler 3 erzeugt durch Umschalten die beiden Eckfrequenzen $f_u$ und $f_o$ des FM-Diskriminators.

Es ergibt sich $f_{Ein} = a\,f_o + b\,f_u$, wobei $a+b = 1$ ist und a und b das Tastverhältnis des dem Frequenzteiler 3 als Steuersignal zugeführten Ausgangssignals des Phasenvergleichers 1 angeben.

Schickt man das Steuersignal durch den Tiefpass 2, so erscheint nach diesem das Niederfrequenzsignal ($U_{NF}$). Die durch den Moduloteiler 3 erzeugten Frequenzen $f_o$ und $f_u$ sind nur von der Quarzfrequenz $f_q$ abhängig, also quarzstabil. Ein Abgleich der Schaltung ist also nicht erforderlich.

Da am Tiefpass ein Tastverhältnis anliegt, kann an dieser Stelle sehr vorteilhaft das Tastverhältnis ausgezählt und so digitalisiert werden. Innerhalb der Schaltung wird das Digitalsignal vor dem Moduloteiler 3 entnommen.

## Patentanspruch

1. Digitaler quarzstabiler FM-Diskriminator mit einer Phasenregelschleife (PLL: Phase Locked Loop), die einen Phasenvergleicher (1) und einen umschaltbaren Frequenzteiler (3) enthält, bei dem dem Phasenvergleicher das Eingangssignal $f_{Ein}$ des Diskriminators und das Ausgangssignal des Frequenzteilers und dem Frequenzteiler eine quarzstabile Frequenz ($f_q$) und das Ausgangssignal des Phasenvergleichers zugeführt werden, dadurch gekennzeichnet, dass im Signalübertragungsweg am Verbindungspunkt vom Ausgang des Phasenvergleichers (1) und Eingang des Frequenzteilers (3) ein Tiefpass (2) eingeschaltet ist, dem das Ausgangssignal des Phasenvergleichers (1) zugeführt wird und dessen Ausgang eine Spannung $U_{Nf}$ entnehmbar ist, dass der Frequenzteiler durch Umschalten ein Signal erzeugt, das die Eckfrequenzen $f_u$ und $f_o$ des Diskriminators enthält und dass die Frequenz des Eingangssignals $f_{Ein} = a\,f_o + b\,f_u$ ist, wobei $a+b = 1$ ist und a und b das Tastverhältnis des dem Frequenzteiler (3) als Steuersignal zugeführten Ausgangssignals des Phasenvergleichers (1) angeben.

## Revendication

1. Discriminateur FM numérique à stabilité de quartz, comprenant une boucle à verrouillage de phase (PLL pour «Phase Locked Loop») qui contient un comparateur de phase (1) et un diviseur de fréquence (3) commutable, dans lequel le signal d'entrée $f_{en}$ du discriminateur et le signal de sortie du diviseur de fréquence sont appliqués au comparateur de phase et une fréquence ($f_q$) à stabilité de quartz et le signal de sortie du comparateur de phase sont appliqués au diviseur de fréquence, caractérisé en ce qu'un filtre passe-bas (2) est interposé dans le chemin de transmission du signal au point de connexion de la sortie du comparateur de phase (1) et de l'entrée du diviseur de fréquence (3), filtre auquel est appliqué le signal de sortie du comparateur de phase (1) et sur la sortie duquel peut être prélevée une tension $U_{Nf}$, que le diviseur de fréquence génère, par commutation, un signal qui contient les fréquences limites $f_u$ et $f_o$ du discriminateur et que la fréquence du signal d'entrée $f_{en}$ est égale à a $f_o$+b $f_u$, où a+b = 1 et a et b indiquent le rapport d'impulsions du signal de sortie du comparateur de phase (1), envoyé en tant que signal de commande au diviseur de fréquence (3).

### Claim

1. Digital crystal-stabilized FM discriminator with a phase locked loop (PLL) which contains a phase comparator (1) and a switchable frequency divider (3), in which the phase comparator is supplied with the input signal $f_{Ein}$ of the discriminator and the output signal of the frequency divider and the frequency divider is supplied with a crystal-stabilized frequency ($f_q$) and the output signal of the phase comparator, characterized in that, in the signal transmission path at the junction of the output of the phase comparator (1) and the input of the frequency divider (3), a low-pass filter (2) is inserted which is supplied with the output signal of the phase comparator (1) and from the output of which a voltage $U_{Nf}$ can be taken, in that the frequency divider generates by switching a signal which contains the corner frequencies $f_u$ and $f_o$ of the discriminator and in that the frequency of the input signal $f_{Ein}$ = a $f_o$+b $f_u$, where a+b = 1 and a and b specify the duty ratio of the output signal of the phase comparator (1) supplied as control signal to the frequency divider (3).

1/1